# EUROPEAN PATENT SPECIFICATION

(11) **EP 4 483 068 B1**
(45) Date of publication and mention of the grant of the patent: **08.04.2026**
(21) Application number: 22850687.9
(22) Date of filing: 14.11.2022
(51) Int. Cl.: F16C 41/00, H02N 2/18, H10N 30/00

(54) **BEARING COMPONENT WITH PIEZOELECTRIC CORE**
LAGERELEMENT MIT PIEZOELEKTRISCHEN KERN
ÉLÉMENT DE PALIER AVEC NOYAU PIÉZOÉLECTRIQUE

(30) Priority: 25.02.2022 US 202263314165 P
(43) Date of publication of application: 01.01.2025
(73) Proprietor: The Timken Company, North Canton, Ohio 44720 (US)
(72) Inventor: KIEFER IV, Louis, New London, NH 03257 (US)
(74) Representative: Stevens Hewlett & Perkins
(86) International application number: PCT/US2022/079795
(87) International publication number: WO 2023/163803

(56) References cited:
- EP-A1- 3 512 721
- EP-A1- 3 730 809
- WO-A1-2013/176411
- CN-B- 110 474 559
- DE-A1- 102010 039 167
- DE-A1- 102020 118 263
- KR-A- 20110 016 798
- US-A- 5 677 488

## Description

### CROSS-REFERENCE TO RELATED APPLICATION

This patent application claims priority and benefit of the filing date of U.S. Provisional Patent Application Serial No. 63/314,165 filed February 25, 2022.

### BACKGROUND

The present embodiments relate to mechanical waste energy harvesting by a mechanical bearing assembly including a bearing component

Various applications of mechanical waste energy harvesting have been developed in recent years in order to convert energy lost in power transmission systems into a usable form, such systems are known for example from EP 3 730 809 A1. In a mechanical bearing assembly, torsional loading strains and friction losses can cause wear on a bearing component and reduce the overall power transmission efficiency of a mechanical system.

Piezoelectric materials, such as quartz, can be utilized to convert a mechanical deflection of a material into an electrical potential (i.e. the principle employed to create a strain gage).

### SUMMARY

An ideal approach to an energy harvesting system is to utilize an internal piezoelectric core with an attached electrical storage device in an attempt to create usable additional electrical power from wasted mechanical energy. The present arrangements contemplate energy harvesting arrangements for efficiently harvesting energy from a bearing component.

One embodiment is directed to a bearing component having an internal core of piezoelectric material for harvesting of mechanical energy. The bearing component comprises: the internal core of piezoelectric material extending circumferentially about an entirety of the bearing component; an insulating layer surrounding the internal core of piezoelectric material; and an external shell surrounding the insulating layer and enclosing the internal core of piezoelectric material and the insulating layer.

Another embodiment is directed to the bearing component including a p-type material and an n-type material contacting opposing portions of the internal core of piezoelectric material to act as an internal power generation mechanism that is isolated from the external shell of the bearing component by the insulating layer. The bearing component includes a power storage device having a respective positive terminal connected by a first lead to the p-type material and a respective negative terminal connected by a second lead to the n-type material disposed in the bearing component, wherein the power storage device receives power generated by torsional loading applied to the bearing component.

In another embodiment, the bearing component includes: an inner alpha layer surrounding the internal core of piezoelectric material; a beta layer surrounding the inner alpha layer; and a gamma layer surrounding the beta layer and in contact with the insulating layer. The alpha layer, the beta layer, and the gamma layer include materials that linearly or exponentially increase or decrease in strength and/or ductility extending in succession from the internal core of piezoelectric material to the insulating layer and the external shell.

In another embodiment, the bearing component for harvesting mechanical energy includes: a piezoelectric element embedded in conductive ductile material, a p-type material and a n-type material contacting opposing portions of the conductive ductile material enclosing the piezoelectric element to act as an internal power generation mechanism, an insulating layer enclosing the piezoelectric element embedded in the conductive ductile material, the p-type material, and the n-type material; and an external shell surrounding the insulating layer and enclosing the piezoelectric element embedded in the conductive ductile material, the p-type material, the n-type material and the insulating layer.

In another embodiment, the bearing component for harvesting mechanical energy includes: a first internal core disposed in a first center location that extends the bearing component, a first p-type material and a first n-type material contacting opposing portions of the first internal core to act as a first internal power generation mechanism. The bearing component further includes a second internal core disposed in a second center location that extends about the bearing component, a second p-type material and a second n-type material contacting opposing portions of the second internal core to act as a second internal power generation mechanism. A separation layer separates the first internal core, the first p-type material and the first n-type material from the second internal core, the second p-type material, and the second n-type material, an insulating layer encloses the first internal core, the first p-type material, the first n-type material, the second internal core, the second p-type material, and the second n-type material, and an external shell surrounds the insulating layer and encloses the first internal core, the first p-type material, the first n-type material, the second internal core, the second p-type material, and the second n-type material.

Other aspects will become apparent by consideration of the detailed description and accompanying drawings.

### BRIEF DESCRIPTION OF THE DRAWINGS

FIG. 1 illustrates an isometric view of a bearing component.
FIG. 2 shows a cross sectional view of the bearing component shown Fig. 1.
FIG. 3 shows a cross sectional view including an internal structure of a piezoelectric bearing component.
FIG. 4 shows a cross sectional view of a finite element analysis for the piezoelectric bearing component of FIG. 3.
Fig. 5 illustrates a cross sectional view of another embodiment of a piezoelectric bearing component.
FIG. 6 illustrates a cross sectional view of yet another embodiment of a piezoelectric bearing component.
FIG. 7 illustrates a perspective view of an internal structure or piezoelectric element for another embodiment of a bearing component.
FIG. 8 illustrates a cross sectional view of another embodiment of a piezoelectric bearing component.
FIG. 9 shows a cross sectional view of the FIG. 8 piezoelectric bearing component that is transverse to the view shown in Fig. 8.
FIG. 10 shows a perspective view of one embodiment for the braids or helical shaped piezoelectric structure shown in FIGS. 8 and 9.
FIG. 11 shows a cut-away perspective view of the piezoelectric bearing component of FIG. 8.
FIG. 12 shows a cross-sectional view of the piezoelectric bearing component of FIG. 11.
FIG. 13 shows a cross section view of yet another embodiment of a piezoelectric bearing component.

### DETAILED DESCRIPTION

Before any embodiments are explained in detail, it is to be understood that the arrangement is not limited in its application to the details of construction and the arrangement of components set forth in the following description or illustrated in the following drawings. The embodiments are capable of being practiced or of being carried out in various ways. Also, it is to be understood that the phraseology and terminology used herein are for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

As should also be apparent to one of ordinary skill in the art, the systems shown in the figures are models of what actual systems might be like. Thus, the invention is defined in the appended claims.

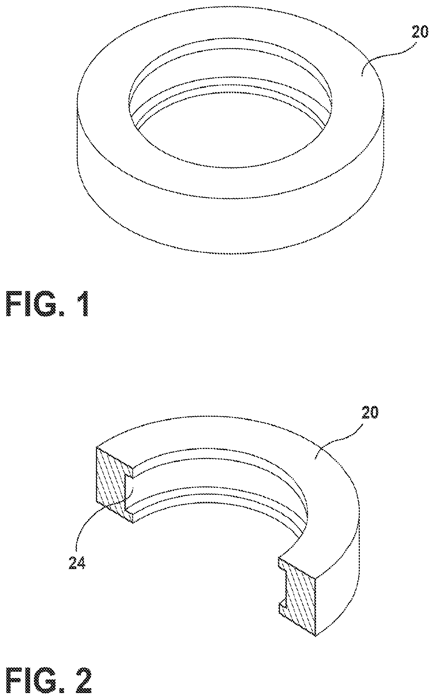

Fig. 1 illustrates a bearing component 20 (i.e. an outer ring) for receiving rolling elements and receiving an internal race (not shown). Fig. 2 shows a cross-section of the bearing component 20 having an inner channel or raceway 24 for receiving rolling elements.

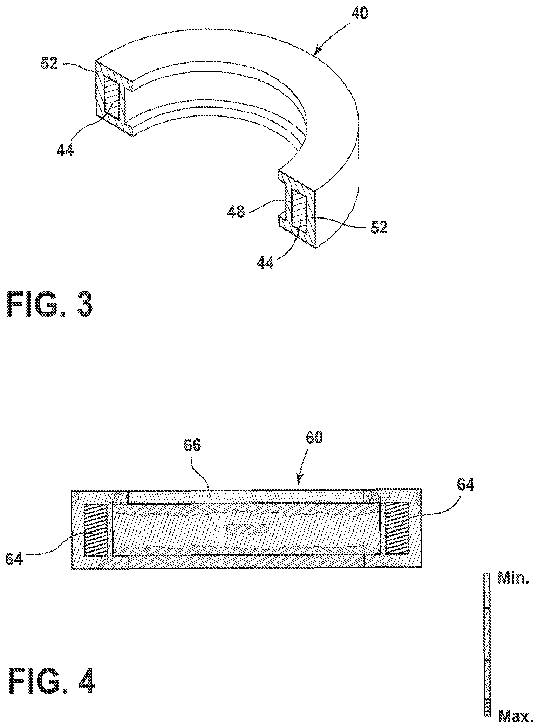

Fig. 3 illustrates a cross sectional view of a bearing component 40 having an internal core of piezoelectric material 44 extending circumferentially about the bearing component 40. In the illustrated embodiment, the material extends about an entirety of the bearing component 40. An insulating layer 48 surrounds the piezoelectric material 44 to provide insulation from an external shell or body 52 of the bearing component 40. In one embodiment, the bearing component 40 is a generally cylindrical outer bearing component or outer ring. Fig. 4 shows finite element analysis 60 for the bearing component 40 showing that a region of the piezoelectric material 44 has maximized strain distribution during use thereof. Another region 66 has a least amount of strain distribution according to finite element analysis. A graph of minimum and maximum strain values is shown at lower right of Fig. 4.

Further information on the operation of the bearing component 40 is disclosed in the operation for the embodiment set forth below.

### EMBODIMENT 2

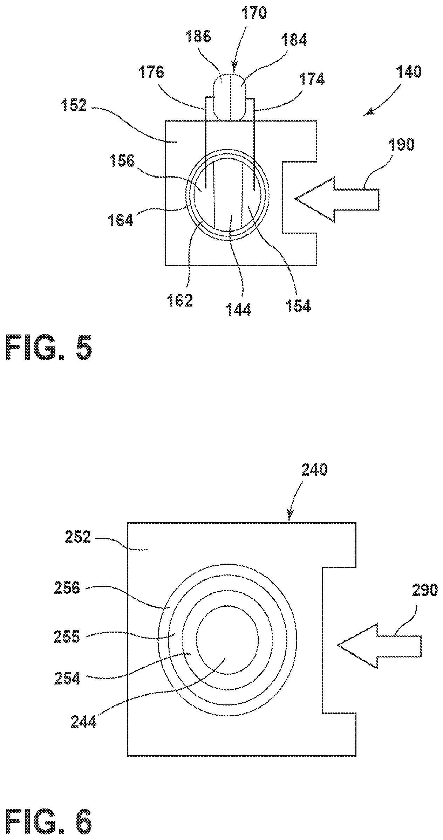

Fig. 5 shows a cross sectional view of one section of another bearing component 140 providing an energy harvesting concept from a functionality point of view. Specifically, in one embodiment, the bearing component 140 is a ring shaped outer ring/race and the working system also could be potentially applied to an inner bearing component as well if the energy storage device is properly secured or coupled to the face of a spinning ring shaped inner bearing component (i.e. inner race). Fig. 5 shows an internal core 144 of piezoelectric material embedded in the center of the bearing component 140 and flanked on either end by materials with electric potential: a p-type material 154 creates a positive voltage end and an n-type material 156 creates a negative voltage end (in a similar fashion to that of a diode). The materials 154, 156 act as an internal power generation mechanism that can then be isolated from an external shell or body 152 of the bearing component 140 by adding an electrically resistive layer to the insulating layer 162 (to prevent shock); which is itself surrounded by a thermally resistive layer 164 to allow for the external shell or body 152 to be cast around the internal elements and layers 154, 156, 162, 164. A power storage device 170 has leads 174, 176 with a respective positive terminal 184 connected by the first lead 174 to the p-type material 154 and a respective negative terminal 186 connected by the second lead 176 to the n-type material 156 disposed in the bearing component 140. In one embodiment, orientating the p-type material 154 to receive the force of the torsional loading shown by arrow 190 in Fig. 5 creates a standard voltage (positive to negative energy flow). In another embodiment, a reversal of the polarities demonstrated in figure 5 (n-type material against a bearing roller path) creates a "negative" voltage (such as that found in a JFET transistor). The p-type material usually includes a silicon wafer doped with boron, which has one less electron than silicon (making the material positively charged). An n-type material is usually doped with phosphorus, which has one more electron than silicon (making the material negatively charged).

In one embodiment, the p-type material 154 and the n-type material 156 contact opposing portions of the internal core 144 of piezoelectric material to act as an internal power generation mechanism that is isolated from the external shell 152 of the bearing component 140 by the insulating layers 162, 164.

In operation, the p-type material 154 and n-type material 156 contact opposing portions of the internal core 144 of piezoelectric material to act as an internal power generation mechanism that is isolated from the external shell or body 152 of the bearing component 140 by the insulating layers 162, 164.

### EMBODIMENT 3

Fig. 6 shows a cross sectional view of one section of another bearing component 240 providing an energy harvesting of mechanical energy concept from a functionality point of view. Specifically, in one embodiment the bearing component 240 is an outer ring shaped outer race and the working system also could be potentially applied to an inner ring/race bearing component as well if an energy storage device is properly secured to the face of a spinning ring shaped inner bearing component (i.e. inner race). For example, in Fig. 6, the internal core of piezoelectric material 244, (simplified as a single circle to retain clarity) is provided within the bearing component 240 having an external shell or body 252. Fig. 6 also shows that an internal force/strain redistribution methodology could be extended to include multiple layers of progressively varying strength or ductility. More specifically, the internal core 244 of piezoelectric material is surrounded by an inner annular alpha layer 254, an outwardly oriented circular or annular shaped cross section of a beta layer 255, and finally an annular shaped gamma layer 256 which include materials that linearly or exponentially increase or decrease in strength and/or ductility (or other variable material properties) as they are added in succession from inside/adjacent the internal core 244 of piezoelectric material to outside adjacent the external shell 252. In one embodiment, the alpha layer 254 is 4340 steel alloy at 190 Gigapascal (GPa) at 25 degrees Celsius, the beta layer 255 is 4340 steel alloy at 195 Gigapascal (Gpa) at 25 degrees Celsius, and the gamma layer 256 is 4340 steel alloy at 205 Gpa at 25 degrees Celsius. This arrangement including the alpha layer 254, the beta layer 255, and the gamma layer 256, in combination, optimize the distribution of stress/strain felt inside a bearing ring formed by the outer or external bearing component 240 to maximize energy harvesting potential and reduce the risk of failure due to the increase of stress concentrations found in composite material at material intersection points. A power storage device, terminals, an electrically resistive layer, and a thermally resistive layer are provided in some embodiments. In one embodiment, the gamma layer 256 acts as a thermally resistive layer and an electrically resistive layer. In another embodiment, an electrically resistive layer and a thermally resistive layer (not shown) are provided between the gamma layer 256 and the external shell or body 252 of the bearing component 240. Fig. 6 shows a direction for torsional loading 290 similar to the direction for the arrangement shown in Fig. 5.

In one embodiment, the alpha layer 254, the beta layer 255, and the gamma layer 256 optimize the distribution of stress/strain sensed inside the internal core 244 of piezoelectric material or a piezoelectric element within the bearing component 240 to maximize energy harvesting potential and reduce the risk of failure due to the increase of stress concentrations found in composite materials at material intersection points. While three layers are shown, other embodiments have 3 to n layers, wherein n represents a maximum value of 8 or more layers in total.

In another embodiment, the alpha layer 254 is 4340 steel alloy at a Rockwell hardness scale (HRC) of 54, the beta layer 255 is 440C steel alloy at HRC 58, and the gamma layer 256 is M50 steel alloy at HRC 63. Again, other embodiments have from 2 to n layers of different materials.

### EMBODIMENT 4

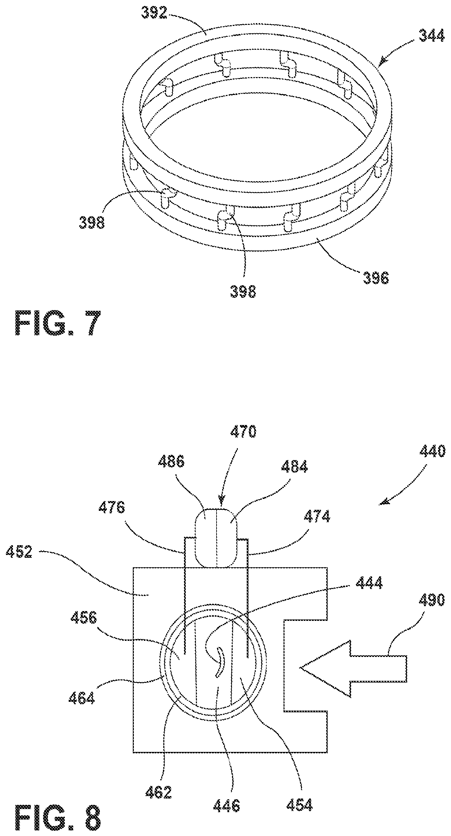

Figure 7 extends the concept of the internal core of piezoelectric material to a geometry that considers alternate shapes and structures that have beneficial reactions to the torsional loading occurring on the outside of the ring for the bearing component. The example of an internal core 344 of piezoelectric material shown in Fig. 7 mimics the helical structure of DNA so that the element is capable of twisting in reaction to torsional loading and further resist fracture. The internal core 344 of piezoelectric material includes a circular or annular shaped first or upper piezoelectric member 392 and a spaced circular or annular shaped second or lower piezoelectric member 396 as shown in Fig. 7. Further, angled piezoelectric connecting elements 398 are provided about the piezoelectric members 392, 396, connecting same with each other. In one embodiment, the angled piezoelectric connecting elements 398 are provided with a first upwardly projecting leg projecting upwardly from the piezoelectric member 396, a second sidewardly projecting or transverse leg and a third upwardly projecting leg that joins to the piezoelectric member 392. The piezoelectric members 392, 396 are spaced apart essentially equidistantly from each other in a shared plane. The angled piezoelectric connecting elements 398 are provided about and connect the annular shaped upper piezoelectric member 392 and the annular shaped lower piezoelectric member 396. The piezoelectric members 392, 396, 398 are embedded in conductive ductile material (not shown) to form the internal core 344 in one embodiment. Thus, the piezoelectric members 392, 396 define two spaced piezoelectric core members. In another embodiment, the internal core 344 of piezoelectric material is surrounded by an insulating layer and encased within an external shell or body of a bearing component.

The internal core 344 of piezoelectric material can be utilized in conjunction with the methodology demonstrated in Figs. 5 and 6, and may potentially be utilized in conjunction with the methodology shown in Fig. 3 as well. The layering effect would be cast around the internal core shape of the bearing component and a power storage device is soldiered into the ring shaped bearing component. In one embodiment, the helical shape of the internal core 344 of piezoelectric material is cast sideways inside a ring of ductile steel alloy that is placed between a P-N junction.

One of skill in the art will understand that with any of the disclosed embodiments a "layer" can have a wide range of thicknesses and shapes. While circular or annular shapes are shown for the layers in Fig. 6, oval and other shapes are contemplated.

### EMBODIMENT 5

Fig. 8 shows a cross sectional view of one section of another bearing component 440 providing an energy harvesting concept from a functionality point of view. Specifically, in one embodiment, the bearing component 440 is a ring shaped outer ring/race and the working system also could be potentially applied to an inner bearing component as well if the energy storage device is properly secured or coupled to the face of a spinning ring shaped inner bearing component (i.e. inner race). Fig. 8 shows embedded braids or a helical shaped piezoelectric structure 444 of piezoelectric material embedded or cast in ductile conductive metal or other material 446 forming a central core structure for the bearing component 440. The conductive ductile core material 446 enclosing the helical shaped piezoelectric structure 444 is flanked on either end by materials with electric potential: a p-type material 454 creates a positive voltage end and an n-type material 456 creates a negative voltage end (in a similar fashion to that of a diode). The materials 454, 456 act as an internal power generation mechanism that can then be isolated from an external shell or body 452 of the external bearing component 440 by adding an electrically resistive layer or insulating layer 462 (to prevent shock); which is itself surrounded by a thermally resistive layer 464 to allow for the external shell or body 452 to be cast around the internal elements and layers 444, 446, 454, 456, 462, 464. A power storage device 470 has leads 474, 476 with a respective positive terminal 484 connected by the first lead 474 to the p-type material 454 and a respective negative terminal 486 connected by the second lead 476 to the n-type material 456 disposed in the bearing component 440. In one embodiment, orientating the p-type material 454 to receive the force of the torsional loading shown by arrow 490 in Fig. 8 creates a standard voltage (positive to negative energy flow). In another embodiment, a reversal of the polarities demonstrated in figure 8 (n-type material against a bearing roller path) creates a "negative" voltage (such as that found in a JFET transistor). The p-type material usually includes a silicon wafer doped with boron, which has one less electron than silicon (making the material positively charged). An n-type material is usually doped with phosphorus, which has one more electron than silicon (making the material negatively charged).

In one embodiment, the p-type material 454 and the n-type material 456 contact opposing portions of the conductive ductile core material 446 encapsulating a helical shaped piezoelectric structure 444 to act as an internal power generation mechanism that is isolated from the external shell 452 of the bearing component 440 by the insulating layers 462, 464.

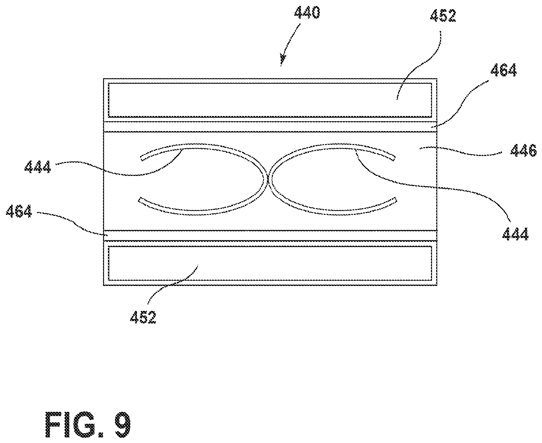

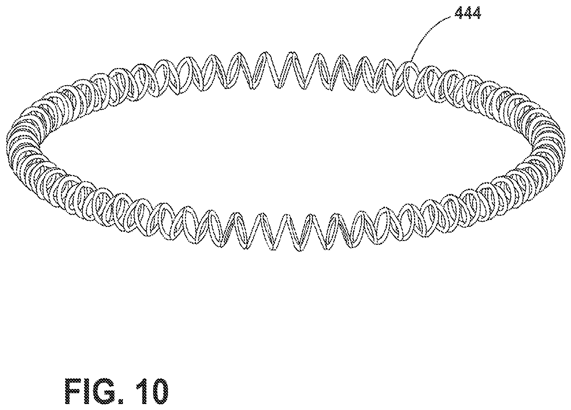

FIG. 9 shows a cross sectional view of the FIG. 8 external bearing component 440 wherein the view is transverse to the FIG. 8 cross sectional view. The helical shape of the braids or helical shaped piezoelectric structure 444 is shown in FIG. 9 that is casted in the conductive ductile core material 446 to form the bearing component 440. Further, FIG. 10 shows an isometric view of the braids defining a helical shaped piezoelectric structure 444. The helical shaped piezoelectric structure 444 shown in Fig. 10 is embedded in the conductive ductile core material 446 shown in Fig. 8.

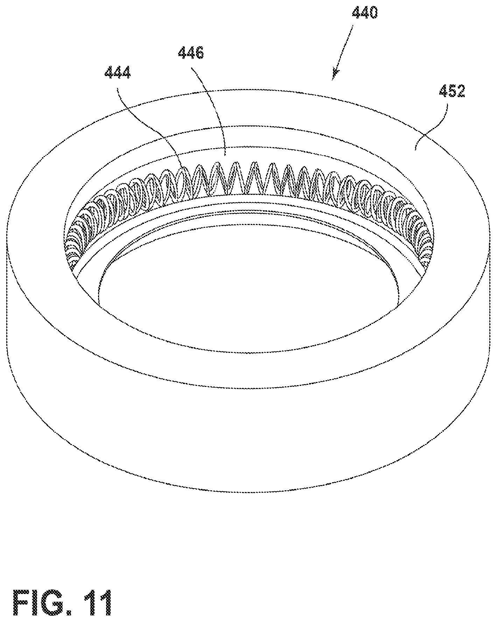

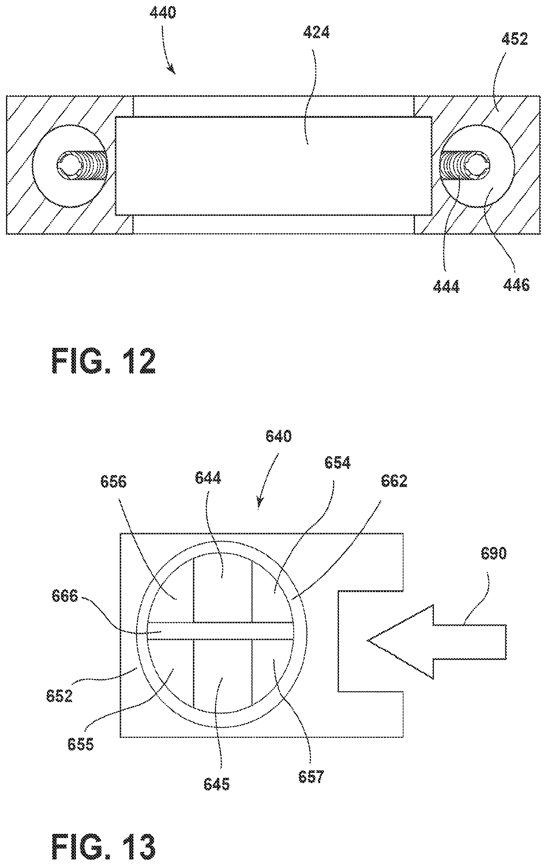

FIG. 11 is a perspective view of a bearing component 440 of the arrangement shown in FIG. 8 without the P-N junction shown. The bearing component 440 includes a conductive ductile core material 446 cut away partially to expose the helical shaped piezoelectric structure 444. The external shell or body 452 is also shown for the bearing component 440. FIG. 12 is a cross-sectional view of the Fig. 11 structure showing a bearing component 440 having the conductive ductile core material 446 surrounding the helical shaped piezoelectric structure 444 and within the external shell or body 452. An inner face of an inner channel or raceway 424 is also illustrated in FIG. 12.

### EMBODIMENT 6

FIG. 13 shows a cross sectional view of one section of another bearing component 640 providing an energy harvesting concept from a functionality point of view. Specifically, in this embodiment, the bearing component 640 is a ring shaped outer ring/race and the working system also could be potentially applied to an inner bearing component as well if the energy storage device is properly secured or coupled to the face of a spinning ring shaped inner bearing component (i.e. inner race). Fig. 13 shows a first or upper internal core 644 of piezoelectric material that in one embodiment includes a first or upper piezoelectric element embedded in conductive ductile material in one embodiment. In another embodiment the first internal core 644 is piezoelectric material. The first or upper internal core 644 is disposed in a first or upper center location of the bearing component 640 that extends about an entirety of the bearing component. A second or lower internal core 645 of piezoelectric material includes a second or lower piezoelectric element embedded in conductive ductile material in the one embodiment. In another embodiment, the second internal core is essentially entirely piezoelectric material. The second or lower internal core 645 is disposed at a second spaced or lower center location of the bearing component 640 and extends about an entirety of the bearing component in one embodiment. The first internal core 644 is disposed spaced above the second internal core 645. The first or upper internal core 644 is flanked on either end or side by materials with electric potential: a first or upper p-type material 654 creates a positive voltage end and an upper or first n-type material 656 creates a negative voltage end (in a similar fashion to that of a diode). The first or upper p-type material 654 and the first or upper n-type material 656 contact opposing portions of the first or upper internal core 644 to act as a first internal power generation mechanism. Likewise, the second or lower internal core 645 including piezoelectric element embedded in ductile material is flanked on either end or side by materials with electric potential: a second or lower p-type material 655 creates a positive voltage end and a second or lower n-type material 657 creates a negative voltage end (in a similar fashion to that of a diode). The first or upper internal core 644, the first or upper p-type material 654, and the first or upper n-type material 656 are separated from the second or lower internal core 645, the second or lower p-type material 655, and the second or lower n-type material 657 by a planar separation layer 666. The planar separation layer 666 insulates the voltages generated and the materials from each other. The separation layer 666 is disposed for separating the first or upper internal core 644, the first or upper p-type material 654 and the first or upper n-type material 656 from the second or lower internal core 645, the second or lower p-type material 655, and the second or lower n-type material 657. As in earlier embodiments, an insulation layer 662 surrounds the entirety of the first or upper materials 644, 654, 656 and the entirety of the second or lower materials 645, 655, 657 to isolate from an external shell or body 652 of the bearing component 640 to prevent shock. In some embodiments, the insulation layer 662 is itself surrounded by an additional thermally resistive layer to allow for the external shell or body 652 to be cast around the first or upper materials and the second or lower materials. In Fig. 13, the first or upper n-type material 656 is separated from the adjacent second or lower p-type material 655 by the separation layer 666. The first p-type material 654 is separated from the adjacent second or lower n-type material 657 by the separation layer 666.

A power storage device (not shown) has leads (not shown) with a respective positive terminal (not shown) connected by the first lead to the first or upper p-type material 654 and a respective negative terminal connected by the second lead to the first or upper n-type material 656 disposed in an upper portion of the bearing component 640 to act as a first internal power generation mechanism. Another pair of terminals are connected by leads to the second or lower p-type material 655 and the second or lower n-type material 657 disposed in a lower portion of the bearing component 640 shown in FIG. 13 to act as a second internal power generation mechanism.

The result shown in Fig. 13 is two P/N style terminals electrically insulated from one another and insulated from each other in the bearing component 640 to allow for two distinct generated voltages. Thus, the mechanical input force of the torsion loading 690 on the bearing component 640 is essentially reduced by one half in the arrangement shown in FIG. 13. The wave output by the piezoelectric voltages generated can be alternating current, but wave modulation circuits are provided in some embodiments so that the voltage output is provided to a user's specifications as needed. Several operational amplifier and digital logic applications utilize positive and negative voltage inputs provided thereto.

In one embodiment, orientating the p-type material 154 to receive the force of the torsional loading shown by arrow 190 in Fig. 5 creates a standard voltage (positive to negative energy flow). In another embodiment, a reversal of the polarities demonstrated in figure 5 (n-type material against a bearing roller path) creates a "negative" voltage (such as that found in a JFET transistor). The p-type material usually includes a silicon wafer doped with boron, which has one less electron than silicon (making the material positively charged). An n-type material is usually doped with phosphorus, which has one more electron than silicon (making the material negatively charged). These materials may be utilized with all of the disclosed embodiments.

In one embodiment, the p-type material 154 and the n-type material 156 contact opposing portions of the internal core 144 of piezoelectric material to act as an internal power generation mechanism that is isolated from the external shell 152 of the bearing component 140 by the insulating layers 162, 164. Other embodiments may have similar arrangements.

The term internal core of piezoelectric material is defined both as a solid core of piezoelectric material and a internal core formed by a piezoelectric element as shown in Figs. 7-11 that is surrounded by ductile material. Elements, such as the piezoelectric element utilized in one embodiment, may also be utilized for an internal core of piezoelectric material for another embodiment disclosed herein.

While Fig. 8 shows a helical shaped piezoelectric structure 444 embedded in ductile material 446, in another embodiment, the combination is replaced by a solid piezoelectric element.

While the internal cores 644, 645 are described as including a piezoelectric element embedded in a conductive ductile material, the cores may also represent a soild piezoelectric element in any other arrangements disclosed herein.

Various features and advantages of the arrangement are set forth in the following claims.

## Claims

1. A bearing component having an internal core of piezoelectric material for harvesting mechanical energy, the bearing component comprising:
the internal core of piezoelectric material extending circumferentially about an entirety of the bearing component;
an insulating layer surrounding the internal core of piezoelectric material;
an external shell surrounding the insulating layer and enclosing the internal core of piezoelectric material and the insulating layer; and
a p-type material and an n-type material contacting opposing portions of the internal core of piezoelectric material to act as an internal power generation mechanism that is isolated from the external shell of the bearing component by the insulating layer.

2. The bearing component of claim 1, wherein the insulating layer includes an electrically resistive layer and a thermally resistive layer.

3. The bearing component of claim 1, including a power storage device having a respective positive terminal connected by a first lead to the p-type material and a respective negative terminal connected by a second lead to the n-type material disposed in the bearing component, wherein the power storage device receives power generated by torsional loading applied to the bearing component.

4. A bearing component having an internal core of piezoelectric material for harvesting mechanical energy, the bearing component comprising:
the internal core of piezoelectric material extending circumferentially about an entirety of the bearing component;
an insulating layer surrounding the internal core of piezoelectric material;
an external shell surrounding the insulating layer and enclosing the internal core of piezoelectric material and the insulating layer
an inner alpha layer surrounding the internal core of piezoelectric material,
a beta layer surrounding the inner alpha layer, and
a gamma layer surrounding the beta layer and in contact with the insulating layer,
wherein the alpha layer, the beta layer, and the gamma layer include materials that linearly or exponentially increase or decrease in strength and/or ductility extending in succession from the internal core of piezoelectric material to the insulating layer and the external shell.

5. The bearing component of claim 1, wherein the internal core of piezoelectric material includes an annular shaped upper piezoelectric member and a spaced annular shaped lower piezoelectric member, the bearing component including angled piezoelectric connecting elements provided about and connecting the annular shaped upper piezoelectric member and the annular shaped lower piezoelectric member.

6. The bearing component of claim 1, wherein the bearing component includes an inner channel, and wherein torsional loading is applied to the inner channel by rolling elements for the harvesting of the mechanical energy, or
wherein the bearing component is a generally cylindrical outer bearing component, or
wherein the internal core of piezoelectric material includes embedded braids or a helical shaped piezoelectric structure disposed within a conductive ductile material.

7. A bearing component for harvesting mechanical energy, the bearing component comprising:
a piezoelectric element embedded in conductive ductile material,
a p-type material and a n-type material contacting opposing portions of the conductive ductile material enclosing the piezoelectric element to act as an internal power generation mechanism,
an insulating layer enclosing the piezoelectric element embedded in the conductive ductile material, the p-type material, and the n-type material; and
an external shell surrounding the insulating layer and enclosing the piezoelectric element embedded in the conductive ductile material, the p-type material, the n-type material and the insulating layer.

8. The bearing component according to claim 7, wherein the piezoelectric element embedded in the conductive ductile material extends circumferentially about an entirety of the bearing component, and
wherein the bearing component includes a power storage device having a respective positive terminal connected by a first lead to the p-type material and a respective negative terminal connected by a second lead to the n-type material disposed in the bearing component, and wherein the power storage device receives power generated by torsional loading applied to the bearing component.

9. The bearing component according to claim 7, wherein the bearing component is a ring shaped bearing component and the piezoelectric element embedded in the conductive ductile material extends about an entirety of the ring shaped bearing component, or
wherein the bearing component includes an inner channel, and wherein torsional loading is applied to the inner channel by rolling elements for the harvesting of the mechanical energy.

10. A bearing component for harvesting mechanical energy, the bearing component comprising:
a first internal core disposed in a first center location that extends the bearing component,
a first p-type material and a first n-type material contacting opposing portions of the first internal core to act as a first internal power generation mechanism,
a second internal core disposed in a second center location that extends about the bearing component,
a second p-type material and a second n-type material contacting opposing portions of the second internal core to act as a second internal power generation mechanism,
a separation layer separating the first internal core, the first p-type material and the first n-type material from the second internal core, the second p-type material, and the second n-type material,
an insulating layer enclosing the first internal core, the first p-type material, the first n-type material, the second internal core, the second p-type material, and the second n-type material, and
an external shell surrounding the insulating layer and enclosing the first internal core, the first p-type material, the first n-type material, the second internal core, the second p-type material, and the second n-type material.

11. The bearing component of claim 10, wherein the first internal core includes a first piezoelectric element embedded in a conductive ductile material, wherein the second internal core includes a second piezoelectric element embedded in a conductive ductile material, and wherein the first internal core disposed at the first center location is disposed above the second internal core.

12. The bearing component of claim 10, including a power storage device having a respective positive terminal connected by a first lead to the first p-type material and a respective negative terminal connected by a second lead to the first n-type material disposed in the bearing component, wherein the power storage device receives power generated by torsional loading applied to the bearing component,
wherein the bearing component is a ring shaped bearing component with an inner channel, and wherein torsional loading is applied to the inner channel by rolling elements for the harvesting of the mechanical energy.

13. The bearing component of claim 10, wherein the first p-type material is separated from the adjacent second n-type material by the separation layer.

14. The bearing component of claim 11, wherein the first piezoelectric element embedded in the conductive ductile material includes embedded braids or a helical shaped piezoelectric structure.

15. The bearing component of claim 4, wherein the alpha layer, the beta layer, and the gamma layer, in combination, optimize a distribution of stress/strain sensed inside the bearing component to maximize energy harvesting potential and reduce a risk of failure due to the increase of stress concentrations found in composite material at material intersection points.

## Patentansprüche

1. Träger-Bauteil mit einem inneren Kern aus piezoelektrischem Material zum Abgreifen von mechanischer Energie, wobei das Träger-Bauteil umfasst:
den inneren Kern aus piezoelektrischem Material, der sich umlaufend um eine Gesamtheit des Träger-Bauteils erstreckt;
eine Isolationsschicht, die den inneren Kern aus piezoelektrischem Material umgibt;
eine äußere Schale, die die Isolationsschicht umgibt und den inneren Kern aus piezoelektrischem Material und die Isolationsschicht einschließt; und
ein Material vom p-Typ und ein Material vom n-Typ, das entgegengesetzte Abschnitte des inneren Kerns aus piezoelektrischem Material kontaktiert, um als innerer Energieerzeugungsmechanismus zu wirken, der von der äußeren Schale des Träger-Bauteils durch die Isolationsschicht isoliert ist.

2. Träger-Bauteil nach Anspruch 1, wobei die Isolationsschicht eine elektrisch ohmsche Schicht und eine thermisch resistive Schicht umfasst.

3. Träger-Bauteil nach Anspruch 1, umfassend ein Energiespeicher-Gerät mit einem jeweiligen positiven Anschlusspunkt, der durch eine erste Leitung an das Material vom p-Typ angeschlossen ist, und einem jeweiligen negativen Anschlusspunkt, der durch eine zweite Leitung an das Material vom n-Typ angeschlossen ist, das im Träger-Bauteil angeordnet ist, wobei das Energiespeicher-Gerät Energie empfängt, die durch die Torsionsbelastung erzeugt ist, die auf das Träger-Bauteil angewendet ist.

4. Träger-Bauteil mit einem inneren Kern aus piezoelektrischem Material zum Abgreifen mechanischer Energie, wobei das Träger-Bauteil umfasst:
den inneren Kern aus piezoelektrischem Material, der sich umlaufend um eine Gesamtheit des Träger-Bauteils erstreckt;
eine Isolationsschicht, die den inneren Kern des piezoelektrischen Materials umgibt;
eine äußere Schale, die die Isolationsschicht umgibt und den inneren Kern aus piezoelektrischem Material und die Isolationsschicht einschließt;
eine innere Alphaschicht, die den inneren Kern aus piezoelektrischem Material umgibt,
eine Betaschicht, die die inneren Alphaschicht umgibt und
eine Gammaschicht, die die Betaschicht umgibt und mit der Isolationsschicht in Kontakt ist,
wobei die Alphaschicht, die Betaschicht und die Gammaschicht Materialien umfassen, die linear oder exponentiell an Stärke und/oder Verformbarkeit zunehmen oder abnehmen und sich in Folge vom inneren Kern aus piezoelektrischem Material zur Isolationsschicht und der äußeren Schale erstrecken.

5. Träger-Bauteil nach Anspruch 1, wobei der innere Kern aus piezoelektrischem Material ein ringförmiges oberes piezoelektrisches Glied und ein beabstandetes ringförmiges unteres piezoelektrisches Glied umfasst, wobei das Träger-Bauteil gewinkelte piezoelektrische Anschlusselemente umfasst, die um das ringförmige obere piezoelektrische Glied und das ringförmige untere piezoelektrische Glied bereitgestellt ist und diese anschließen.

6. Träger-Bauteil nach Anspruch 1, wobei das Träger-Bauteil einen inneren Kanal umfasst und wobei die Torsionsbelastung auf den inneren Kanal durch rollende Elemente zum Abgreifen der mechanischen Energie angewendet ist oder
wobei das Träger-Bauteil ein allgemein zylindrisches äußeres Träger-Bauteil ist oder
wobei der innere Kern aus piezoelektrischem Material eingebaute Litzen oder eine spiralförmige, piezoelektrische Struktur umfasst, die innerhalb eines leitenden, verformbaren Materials angeordnet ist.

7. Träger-Bauteil zum Abgreifen von mechanischer Energie, wobei das Träger-Bauteil umfasst:
ein piezoelektrisches Element, das in leitendes, verformbares Material eingebaut ist,
ein Material vom p-Typ und ein Material vom n-Typ, das entgegengesetzte Abschnitte des leitendenten, verformbaren Materials kontaktiert, das das piezoelektrische Element umschließt, um als ein innerer Energieerzeugungsmechanismus zu wirken,
eine Isolationsschicht, die das piezoelektrische Element umschließt, das in das leitende, verformbare Material, das Material vom p-Typ und das Material vom n-Typ eingebaut ist; und
eine äußere Schale, die die Isolationsschicht umgibt und das piezoelektrische Element umschließt, das in das leitende, verformbare Material, das Material vom p-Typ, das Material vom n-Typ und die Isolationsschicht eingebaut ist.

8. Träger-Bauteil nach Anspruch 7, wobei das piezoelektrische Element, das in das leitende, verformbare Material eingebaut ist, sich umlaufend um eine Gesamtheit des Träger-Bauteils erstreckt und wobei das Träger-Bauteil ein Energiespeichergerät mit einem jeweiligen positiven Anschlusspunkt umfasst, der durch eine erste Leitung an das Material vom p-Typ angeschlossen ist, und einen jeweiligen negativen Anschlusspunkt, der durch eine zweite Leitung an das Material vom p-Typ angeschlossen ist, das im Träger-Bauteil angeordnet ist, und wobei das Energiespeichergerät Energie empfängt, die durch Torsionsbelastung erzeugt ist, die auf das Träger-Bauteil angewendet ist.

9. Träger-Bauteil nach Anspruch 7, wobei das Träger-Bauteil ein ringförmiges Träger-Bauteil ist und sich das piezoelektrische Material, das in dem leitfähigen, verformbaren Material eingebaut ist, um eine Gesamtheit des ringförmigen Träger-Bauteils erstreckt oder
wobei das Träger-Bauteil einen inneren Kanal umfasst und wobei die Torsionsbelastung auf den inneren Kanal durch rollende Elemente zum Abgreifen der mechanischen Energie angewendet ist.

10. Träger-Bauteil zum Abgreifen von mechanischer Energie, wobei das Träger-Bauteil umfasst:
einen ersten inneren Kern, der in einer ersten Zentrumsstelle angeordnet ist, die das Träger-Bauteil verlängert,
ein erstes Material vom p-Typ und ein erstes Material vom n-Typ, das entgegengesetzte Abschnitte des ersten inneren Kerns kontaktiert, um als ein erster innerer Energieerzeugungsmechanismus zu wirken,
einen zweiten inneren Kern, der in einer zweiten Zentrumsstelle angeordnet ist, die sich um das Träger-Bauteil erstreckt,
ein zweites Material vom p-Typ und ein zweites Material vom n-Typ, das entgegengesetzte Abschnitte des zweiten inneren Kerns kontaktiert, um als ein zweiter innerer Energieerzeugungsmechanismus zu wirken,
eine Trennschicht, die den ersten inneren Kern, das erste Material vom p-Typ und das erste Material vom n-Typ von dem zweiten inneren Kern, dem zweiten Material vom p-Typ und dem zweiten Material vom n-Typ trennt, eine Isolationsschicht, die den ersten inneren Kern, das erste Material vom p-Typ, das erste Material vom n-Typ, den zweiten inneren Kern, das zweite Material vom p-Typ und das zweite Material vom n-Typ umschließt, und eine äußere Schale, die die Isolationsschicht umgibt und den ersten inneren Kern, das erste Material vom p-Typ, das erste Material vom n-Typ, den zweiten inneren Kern, das zweite Material vom p-Typ und das zweite Material vom n-Typ umschließt.

11. Träger-Bauteil nach Anspruch 10, wobei der erste innere Kern ein erstes piezoelektrisches Element umfasst, das in einem leitenden, verformbaren Material eingebaut ist, wobei der zweite innere Kern ein zweites piezoelektrisches Element umfasst, das in einem leitenden, verformbaren Material eingebaut ist, und wobei der erste innere Kern, der an der ersten Zentrumsstelle angeordnet ist, oberhalb des zweiten inneren Kerns angeordnet ist.

12. Träger-Bauteil nach Anspruch 10, umfassend ein Energiespeichergerät mit einem jeweiligen positiven Anschlusspunkt, der durch eine erste Leitung an das erste Material vom p-Typ angeschlossen ist, und einen jeweiligen negativen Anschlusspunkt, der durch eine zweite Leitung an das erste Material vom n-Typ angeschlossen ist, das im Träger-Bauteil angeordnet ist, wobei das Energiespeichergerät Energie empfängt, die durch Torsionsbelastung erzeugt ist, die auf das Träger-Bauteil angewendet ist,
wobei das Träger-Bauteil ein ringförmiges Träger-Bauteil mit einem inneren Kanal ist und wobei die Torsionsbelastung auf den inneren Kanal durch rollende Elemente zum Abgreifen der mechanischen Energie angewendet ist.

13. Träger-Bauteil nach Anspruch 10, wobei das erste Material vom p-Typ von dem anliegenden zweiten Material vom n-Typ durch die Trennungsschicht getrennt ist.

14. Träger-Bauteil nach Anspruch 11, wobei das erste piezoelektrische Element, das in das leitende, verformbare Material eingebaut ist, eingebaute Litzen oder eine spiralförmige, piezoelektrische Struktur umfasst.

15. Träger-Bauteil nach Anspruch 4, wobei die Alphaschicht, die Betaschicht und die Gammaschicht in Kombination eine Verteilung von Spannung/Belastung optimieren, die innerhalb des Träger-Bauteils erfasst ist, um das Energieabgreif-Potenzial zu maximieren und ein Ausfallrisiko aufgrund von erhöhten Spannungskonzentrationen, im Verbundmaterial an Materialschnittpunkten vorhanden sind, zu reduzieren.

## Revendications

1. Composant de palier comportant un noyau interne de matériau piézoélectrique pour la récupération d'énergie mécanique, le composant de palier comprenant :
le noyau interne de matériau piézoélectrique, qui s'étend circonférentiellement autour de l'entièreté du composant de palier ;
une couche isolante entourant le noyau interne de matériau piézoélectrique ;
une enveloppe externe entourant la couche isolante et renfermant le noyau interne de matériau piézoélectrique et la couche isolante ; et
un matériau de type p et un matériau de type n en contact avec des portions opposées du noyau interne de matériau piézoélectrique pour agir comme un mécanisme de génération d'énergie interne qui est isolé de l'enveloppe externe du composant de palier par la couche isolante.

2. Composant de palier selon la revendication 1, dans lequel la couche isolante inclut une couche électriquement résistive et une couche thermiquement résistive.

3. Composant de palier selon la revendication 1, incluant un dispositif de stockage d'énergie comportant une borne positive respective connectée par un premier conducteur au matériau de type p et une borne négative respective connectée par un deuxième conducteur au matériau de type n disposé dans le composant de palier, dans lequel le dispositif de stockage d'énergie reçoit l'énergie générée par une charge de torsion appliquée au composant de palier.

4. Composant de palier comportant un noyau interne de matériau piézoélectrique pour la récupération d'énergie mécanique, le composant de palier comprenant :
le noyau interne de matériau piézoélectrique, qui s'étend circonférentiellement autour de l'entièreté du composant de palier ;
une couche isolante entourant le noyau interne de matériau piézoélectrique ;
une enveloppe externe entourant la couche isolante et renfermant le noyau interne de matériau piézoélectrique et la couche isolante ;
une couche alpha interne entourant le noyau interne de matériau piézoélectrique ;
une couche bêta entourant la couche alpha interne ; et une couche gamma entourant la couche bêta et en contact avec la couche isolante,
dans lequel la couche alpha, la couche bêta et la couche gamma incluent des matériaux dont la résistance et/ou la ductilité augmentent ou diminuent de manière linéaire ou exponentielle successivement depuis le noyau interne de matériau piézoélectrique jusqu'à la couche isolante et à l'enveloppe externe.

5. Composant de palier selon la revendication 1, dans lequel le noyau interne de matériau piézoélectrique inclut un élément piézoélectrique supérieur de forme annulaire et un élément piézoélectrique inférieur de forme annulaire espacé, le composant de palier incluant des éléments de connexion piézoélectriques inclinés pourvus circonférentiellement et connectant l'élément piézoélectrique supérieur de forme annulaire et l'élément piézoélectrique inférieur de forme annulaire.

6. Composant de palier selon la revendication 1,
dans lequel le composant de palier inclut un canal interne, et dans lequel une charge de torsion est appliquée au canal interne par des éléments roulants pour la récupération de l'énergie mécanique, ou
dans lequel le composant de palier est un composant de palier externe généralement cylindrique, ou
dans lequel le noyau interne de matériau piézoélectrique inclut des tresses intégrées ou une structure piézoélectrique de forme hélicoïdale disposée dans un matériau conducteur ductile.

7. Composant de palier pour la récupération d'énergie mécanique, le composant de palier comprenant :
un élément piézoélectrique intégré dans un matériau conducteur ductile ;
un matériau de type p et un matériau de type n en contact avec des portions opposées du matériau conducteur ductile qui renferme l'élément piézoélectrique pour agir comme un mécanisme de génération d'énergie interne ;
une couche isolante renfermant l'élément piézoélectrique intégré dans le matériau conducteur ductile, le matériau de type p et le matériau de type n ; et
une enveloppe externe entourant la couche isolante et renfermant l'élément piézoélectrique intégré dans le matériau conducteur ductile, le matériau de type p, le matériau de type n et la couche isolante.

8. Composant de palier selon la revendication 7,
dans lequel l'élément piézoélectrique intégré dans le matériau conducteur ductile s'étend circonférentiellement autour de l'entièreté du composant de palier, et
dans lequel le composant de palier inclut un dispositif de stockage d'énergie comportant une borne positive respective connectée par un premier conducteur au matériau de type p et une borne négative respective connectée par un deuxième conducteur au matériau de type n disposé dans le composant de palier, et
dans lequel le dispositif de stockage d'énergie reçoit l'énergie générée par une charge de torsion appliquée au composant de palier.

9. Composant de palier selon la revendication 7,
dans lequel le composant de palier est un élément de palier de forme annulaire, et l'élément piézoélectrique intégré dans le matériau conducteur ductile s'étend autour de l'entièreté de l'élément de palier de forme annulaire, ou
dans lequel le composant de palier inclut un canal interne, et dans lequel une charge de torsion est appliquée au canal interne par des éléments roulants pour la récupération de l'énergie mécanique.

10. Composant de palier pour la récupération d'énergie mécanique, le composant de palier comprenant :
un premier noyau interne disposé dans un premier emplacement central qui prolonge le composant de palier,
un premier matériau de type p et un premier matériau de type n en contact avec des portions opposées du premier noyau interne pour constituer un premier mécanisme de génération d'énergie interne,
un deuxième noyau interne disposé dans un deuxième emplacement central qui s'étend autour du composant de palier,
un deuxième matériau de type p et un deuxième matériau de type n en contact avec des portions opposées du deuxième noyau interne pour agir comme un deuxième mécanisme de génération d'énergie interne,
une couche de séparation séparant le premier noyau interne, le premier matériau de type p et le premier matériau de type n du deuxième noyau interne, du deuxième matériau de type p et du deuxième matériau de type n,
une couche isolante renfermant le premier noyau interne, le premier matériau de type p, le premier matériau de type n, le deuxième noyau interne, le deuxième matériau de type p et le deuxième matériau de type n, et
une enveloppe externe entourant la couche isolante et renfermant le premier noyau interne, le premier matériau de type p, le premier matériau de type n, le deuxième noyau interne, le deuxième matériau de type p et le deuxième matériau de type n.

11. Composant de palier selon la revendication 10, dans lequel le premier noyau interne inclut un premier élément piézoélectrique intégré dans un matériau conducteur ductile, dans lequel le deuxième noyau interne inclut un deuxième élément piézoélectrique intégré dans un matériau conducteur ductile, et dans lequel le premier noyau interne disposé au premier emplacement central est disposé au-dessus du deuxième noyau interne.

12. Composant de palier selon la revendication 10, incluant un dispositif de stockage d'énergie comportant une borne positive respective connectée par un premier conducteur au premier matériau de type p, et une borne négative respective connectée par un deuxième conducteur au premier matériau de type n disposé dans le composant de palier,
dans lequel le dispositif de stockage d'énergie reçoit l'énergie générée par une charge de torsion appliquée au composant de palier,
dans lequel le composant de palier est un composant de palier de forme annulaire comportant un canal interne, et
dans lequel une charge de torsion est appliquée au canal interne par des éléments roulants pour la récupération de l'énergie mécanique.

13. Composant de palier selon la revendication 10, dans lequel le premier matériau de type p est séparé du deuxième matériau de type n adjacent par la couche de séparation.

14. Composant de palier selon la revendication 11, dans lequel le premier élément piézoélectrique intégré dans le matériau conducteur ductile inclut des tresses intégrées ou une structure piézoélectrique de forme hélicoïdale.

15. Composant de palier selon la revendication 4, dans lequel la couche alpha, la couche bêta et la couche gamma optimisent, en combinaison, une distribution des contraintes/déformations détectées à l'intérieur du composant de palier afin de maximiser le potentiel de récupération d'énergie et de réduire le risque de défaillance dû à l'augmentation des concentrations de contraintes trouvées dans le matériau composite aux points d'intersection des matériaux.
